# EUROPEAN PATENT APPLICATION

(11) **EP 2 696 374 A1**
(43) Date of publication of application: **12.02.2014**
(21) Application number: 12753371.9
(22) Date of filing: 22.06.2012
(51) Int. Cl.: H01L 31/18, H01L 31/042

(54) **SUBSTRATE PROCESSING SYSTEM HAVING FUNCTION FOR PREVENTING DAMAGE**

(30) Priority: 14.06.2012 KR 20120063954
(71) Applicant: SNU Precision Co., Ltd., Seoul 151-818 (KR)
(72) Inventor: PARK, Sang Hyun, Chungcheongnam-do 336-719 (KR); LEE, Dong Hyun, Gyeonggi-do 456-715 (KR); OH, Hyun Pil, Gwangju 506-779 (KR); JEON, Kwang Jin, Busan 608-765 (KR); KWON, Jin Haon, Chungcheongnam-do 331-964 (KR); PARK, Sung Jin, Incheon 403-833 (KR)
(74) Representative: Berggren Oy Ab
(86) International application number: PCT/KR2012/004933
(87) International publication number: WO 2013/187547

(57) **Abstract**

Disclosed is a substrate processing system with a damage preventing function, comprising: a fluid tank which stores fluid; a chamber which receives the fluid from the fluid tank and provides a space where a substrate is processed; a pipe which connects the fluid tank and the chamber and through which the fluid flows; and a damage preventing unit which allows the fluid tank to be changed in position corresponding to thermal expansion caused in the pipe by receiving heat as the fluid flows in the pipe. With this, the substrate processing system with the damage preventing function for allowing the fluid tank to correspond to change in volume due to the thermal expansion of the pipe and preventing the fluid tank from damage is provided.

## Description

### CROSS-REFERENCE TO RELATED APPLICATION

This application claims the priority and the benefit to Korean Patent Application No. 10-2012-0063954 filed in the Korean Intellectual Property Office on June 14, 2012, the entire contents of which are incorporated herein by reference.

### BACKGROUND OF THE INVENTION

### (a) Field of the Invention

The present invention relates to a substrate processing system with a damage preventing function, and more particularly to a substrate processing system with a damage preventing function, which includes a damage preventing unit to prevent a fluid tank from damage.

### (b) Description of the Related Art

In modern times, a tank capable of storing gas or liquid and gasifying the liquid has been widely spread and is much helpful in real life or industrial activity.

With increased demand for a semiconductor and a solar cell based on recent rapid development of industrial activity for the semiconductor and the solar cell, there is growing use of the tank capable of storing fluid for manufacturing a thin film for the semiconductor and the solar cell.

Meanwhile, a sputtering method is used as a method of manufacturing the thin film for the solar cell. In the sputtering method, the fluid stored in the tank is gasified and supplied to a vacuum chamber via a pipe, and a deposition material of an atomic or molecular unit is coagulated on a surface of a substrate, thereby forming a thin film.

However, the pipe receives much heat from the flowing gas and expands while the material for forming the thin film is gasified and flows in the pipe.

Therefore, the volume change due to the thermal expansion of the pipe connected between the fluid tank and the chamber may cause damage to the fluid tank and the chamber.

### SUMMARY OF THE INVENTION

Accordingly, the present invention is conceived to solve the forgoing problems, and an aspect of the present invention is to provide a substrate processing system with a damage preventing function which includes a damage preventing unit to prevent a fluid tank and a pipe from damage due to thermal expansion of the pipe.

One aspect of the present invention provides a substrate processing system with a damage preventing function including: a fluid tank which stores fluid; a chamber which receives the fluid from the fluid tank and provides a space where a substrate is processed; a pipe which connects the fluid tank and the chamber and through which the fluid flows; and a damage preventing unit which allows the fluid tank to be changed in position corresponding to thermal expansion caused in the pipe by receiving heat s the fluid flows in the pipe.

The damage preventing unit may include a leg unit which includes one end connected to the fluid tank and the other end supporting a weight of the fluid tank; and a supporting member which includes one side fixed on the ground and the other end contacting the leg unit to limit a movable range of the leg unit.

The leg unit may include a frame supporting the fluid tank; and a rotation member provided as a spherical shape under the frame and movable or rotatable while contacting a top of the supporting member.

The top of the supporting member may include a recessed portion that is recessed inward and has a curvature to prevent the rotation member from breaking away from the supporting member.

### BRIEF DESCRIPTION OF THE DRAWINGS

The above and/or other aspects of the present invention will become apparent and more readily appreciated from the following description of the exemplary embodiments, taken in conjunction with the accompanying drawings, in which:
Fig. 1 is a perspective view of a substrate processing system with a damage preventing function according to an exemplary embodiment;
Fig. 2 is an enlarged perspective view of a damage preventing unit according to an exemplary embodiment;
Fig. 3 is a front view of the coupling relationship of the damage preventing unit according to an exemplary embodiment; and
Fig. 4 schematically illustrates an operation of the damage preventing unit according to an exemplary embodiment.

### DETAILED DESCRIPTION OF THE EMBODIMENTS

Prior to description, elements will be representatively explained in first exemplary embodiment, in which like reference numerals refer to like elements throughout, and different configurations to those of first exemplary embodiment will be described in other exemplary embodiments.

Hereinafter, a substrate processing system with a damage preventing function according to an exemplary embodiment will be described in detail with reference to accompanying drawings.

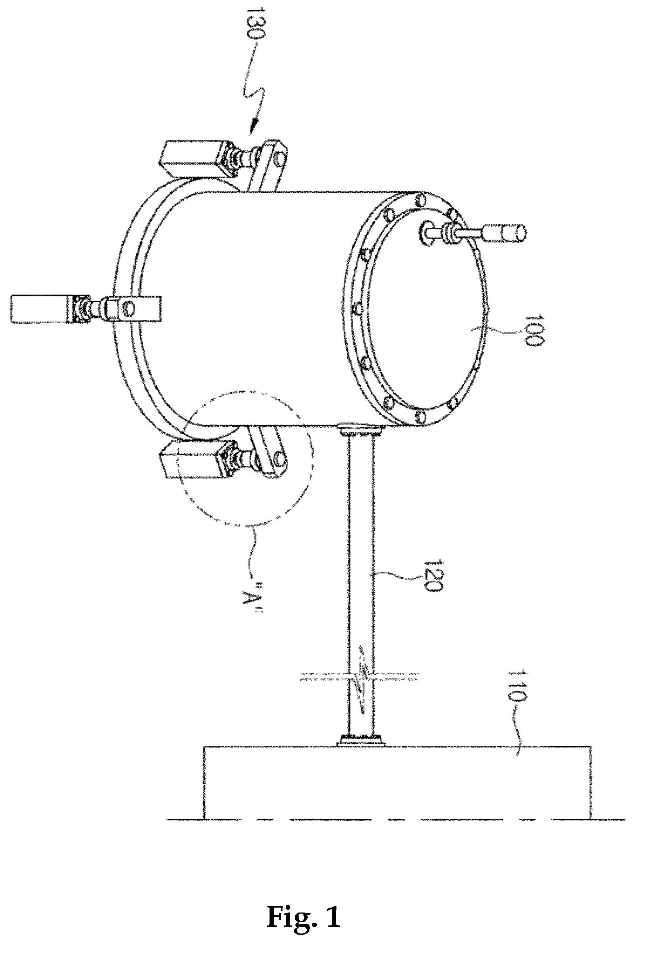

Fig. 1 is a perspective view of a substrate processing system with a damage preventing function according to an exemplary embodiment.

Referring to Fig. 1, the substrate processing system with the damage preventing function according to this exemplary embodiment includes a fluid tank 100, a chamber 110, a pipe 120, and a damage preventing unit 130.

The fluid tank 100 is a member for storing fluid to be jet through a nozzle in the chamber 110 to be described later. The pipe 120 is provided at one side of an outer wall of the fluid tank 100. The pipe 120 is connected to the chamber 110 during a deposition process of manufacturing a thin film for a solar cell and allows gasified fluid to flow therein.

Also, the fluid tank 100 may include a gasifying device (not shown) for gasifying the fluid to be jet to a substrate, a temperature sensing module (not shown) for sensing the temperature of the gasified gas, etc.

In this exemplary embodiment, the gasified gas is selenium for manufacturing the thin film for the solar cell, but not limited thereto. Alternatively, various kinds of fluid may be employed.

The chamber 110 receives the gasified gas from the fluid tank 100, and accommodates the substrate, on which sources jet from the nozzle (not shown) provided in the chamber 110 will be deposited, therein.

The chamber 110 provides a predetermined space for jetting the source to the substrate, and is steady fixed on the ground.

Although it is not shown, a vacuum pump (not shown) may be provided so that a user can control the chamber 110 to be in a vacuum or have desired internal pressure. The chamber 110 may include the nozzle (not shown) for uniformly jetting the fluid to the substrate.

Further, the chamber 110 may include a pressure sensing module (not shown) for sensing the pressure, and may internally include a substrate carrying device (not shown) for carrying the substrate during the deposition process and a substrate supporter (not shown) for stably supporting the substrate in the chamber 110.

Also, the chamber 110 may include a heating member (not shown) for heating the substrate to a predetermined temperature for easy deposition, and the like general parts of the substrate processing system.

The pipe 120 connects the fluid tank 100 and the chamber 110, and allows the source for manufacturing the thin film to flow therein. The pipe 120 has one end connected to the fluid tank 100, and the other end connected to the chamber 110.

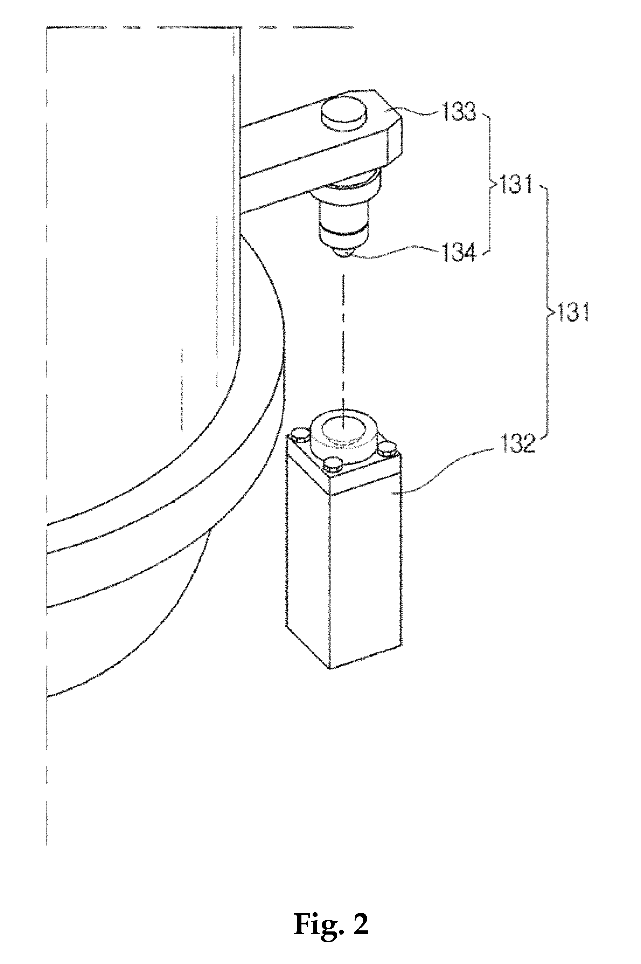

Fig. 2 is an enlarged perspective view of the damage preventing unit 130 according to an exemplary embodiment.

Fig. 2 is an enlarged view of "A" in Fig. 1. Referring to Fig. 2, the damage preventing unit 130 allows the fluid tank to move corresponding to the thermal expansion of the pipe 120 receiving heat from the fluid when the gasified fluid flows therein, thereby preventing the damage.

The damage preventing unit 130 includes a leg unit 131 and a supporting member 132. The leg unit 131 has one end connected to the fluid tank 100, and the other end supporting the weight of the fluid tank 100. The leg unit 131 includes a frame 133 and a rotation member 134.

The frame 133 is mounted to the fluid tank 100, and supports the weight of the fluid tank 100. The frame 133 connects the rotation member 134 and the fluid tank 100, and allows the fluid tank 100 to move together with the rotation member 134 when the rotation member 134 moves or rotates.

In this exemplary embodiment, three frames 133 are provided, but not limited thereto. Alternatively, a single or a plurality of frames 133 may be provided as long as it can support the weight of the fluid tank 100.

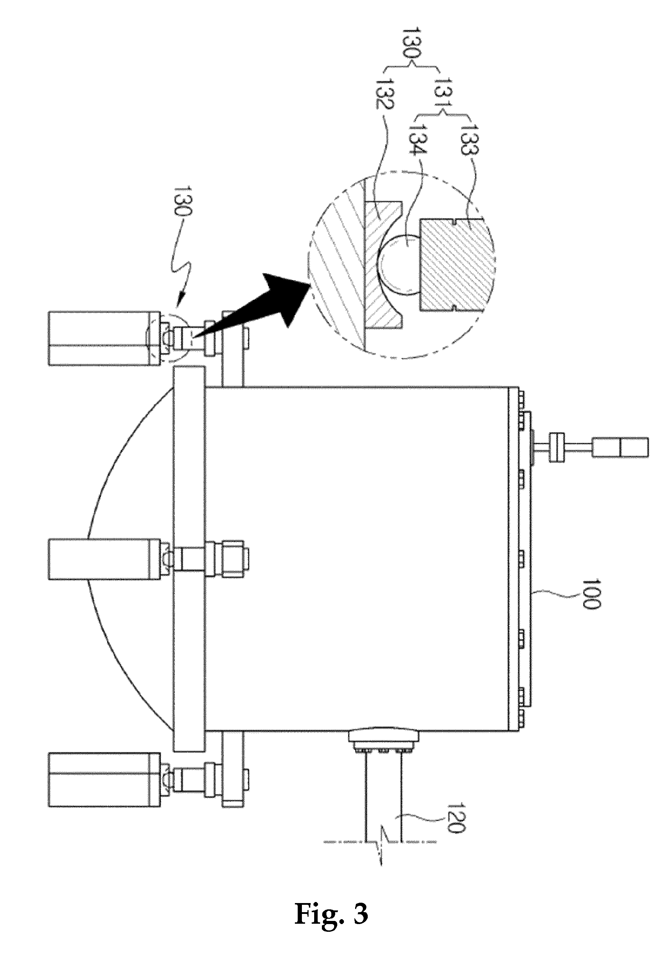

Fig. 3 is a front view coupling relationship of the damage preventing unit according to an exemplary embodiment.

Referring to Fig. 3, the rotation member 134 is provided as a spherical shape under the frame 133. The rotation member 134 may be installed to be rotatable or movable so that the fluid tank 100 can easily move corresponding to the thermal expansion of the pipe 120.

The supporting member 132 has a top contacting the rotation member 134, and a bottom fixed on the ground. The top of the supporting member 132 has a recessed portion having a curvature and recessed inward.

That is, the rotation member 134 connected to the fluid tank 100 via the frame 133 can move or rotate within the recessed portion without limitation in accordance with the thermal expansion of the pipe 120, thereby preventing the fluid tank 100 from damage.

From now on, an operation of the fluid tank 100 having the foregoing damage preventing function according to the exemplary embodiment will be described.

If the substrate is carried by the substrate carrying device (not shown) within the vacuous chamber 110, selenium is supplied as the fluid for manufacturing the thin film from an external certain storage to the fluid tank 100 through the pipe 120.

Selenium supplied to the fluid tank 100 is gasified by the gasifying device (not shown) in the fluid tank 100 and flows in the pipe 120 connected to the fluid tank 100. Gasified selenium flows toward the inside of the vacuous chamber 110 and is jet to the substrate at certain pressure through the nozzle (not shown) provided in the chamber 110.

At this time, gasified selenium flows into the chamber 110 via the pipe 120. The pipe 120 receives heat from gasified selenium and expands. As the pipe 120 increases in volume due to the thermal expansion, a space between the chamber 110 and the fluid tank 110 connected through the pipe 120 becomes larger.

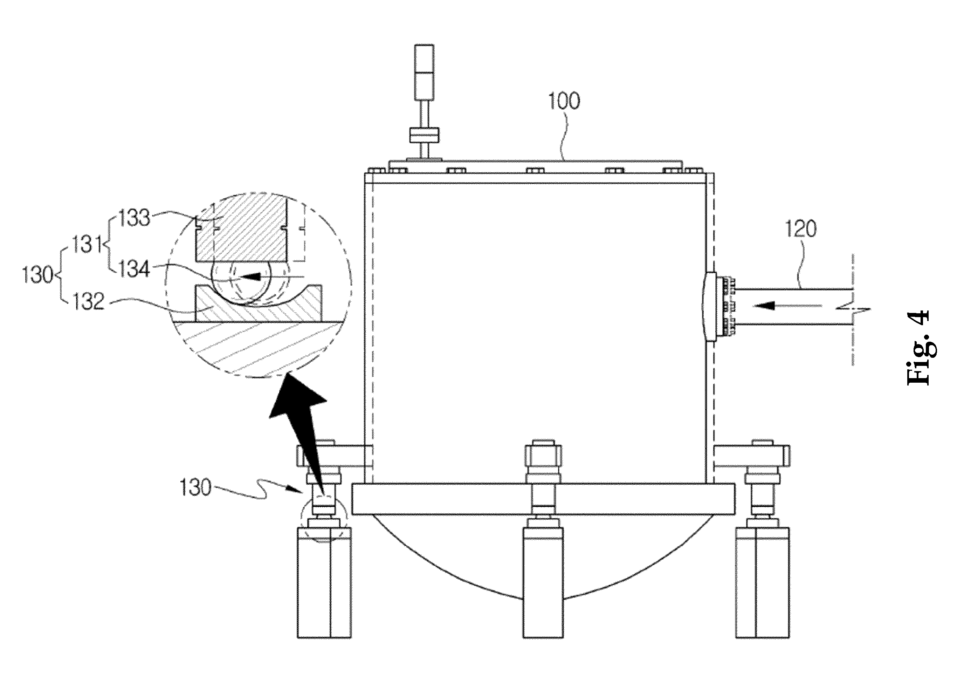

Fig. 4 schematically illustrates an operation of the damage preventing unit 130 according to an exemplary embodiment.

Referring to Fig. 4, the rotation member 134 provided in the damage preventing unit 130 may operate corresponding to the change in the volume of the pipe 120 as the space between the chamber 110 and the fluid tank 110 becomes larger. The rotation member 134 moves and rotates within the space provided on the top of the supporting member 132 as much as the length increased by the thermal expansion, and changes the position of the fluid tank 100, thereby preventing the damage.

Like a conventional structure where the chamber and the fluid tank are steady fixed on the ground, the chamber 110 according to the present exemplary embodiment is also fixed on the ground.

However, the rotation member 134 allowing the fluid tank 100 to be movable and rotatable is provided to prevent the chamber 110 and the fluid tank 100 from damage.

While this invention has been described in connection with what is presently considered to be practical exemplary embodiments, it is to be understood that the invention is not limited to the disclosed embodiments, but, on the contrary, is intended to cover various modifications and equivalent arrangements included within the spirit and scope of the appended claims.

### INDUSTRIAL APPLICABILITY

According to an exemplary embodiment, there is provided a substrate processing system with a damage preventing function, which employs a damage preventing unit for preventing a fluid tank and a pipe from damage due to thermal expansion of the pipe.

## Claims

1. A substrate processing system with a damage preventing function, comprising:
a fluid tank which stores fluid;
a chamber which receives the fluid from the fluid tank and provides a space where a substrate is processed;
a pipe which connects the fluid tank and the chamber and through which the fluid flows; and
a damage preventing unit which allows the fluid tank to be changed in position corresponding to thermal expansion caused in the pipe by receiving heat as the fluid flows in the pipe.

2. The substrate processing system according to claim 1, wherein the damage preventing unit comprises:
a leg unit which comprises one end connected to the fluid tank and the other end supporting a weight of the fluid tank; and
a supporting member which comprises one side fixed on the ground and the other end contacting the leg unit to limit a movable range of the leg unit.

3. The substrate processing system according to claim 2, wherein the leg unit comprises a frame supporting the fluid tank; and a rotation member provided as a spherical shape under the frame and movable or rotatable while contacting a top of the supporting member.

4. The substrate processing system according to claim 2, wherein the top of the supporting member comprises a recessed portion that is recessed inward and the recessed portion has a curvature to prevent the rotation member from breaking away from the supporting member

5. The substrate processing system according to claim 3, wherein the top of the supporting member comprises a recessed portion that is recessed inward and the recessed portion has a curvature to prevent the rotation member from breaking away from the supporting member.
